# EUROPEAN PATENT APPLICATION

(11) **EP 3 261 263 A1**
(43) Date of publication of application: **27.12.2017**
(21) Application number: 15882620.6
(22) Date of filing: 19.02.2015
(51) Int. Cl.: H04B 5/02

(54) **SIGNAL PROCESSING DEVICE**

(71) Applicant: Pezy Computing K.K., Tokyo 101-0052 (JP)
(72) Inventor: SAITO, Motoaki, Tokyo 101-0052 (JP)
(74) Representative: Ström & Gulliksson AB
(86) International application number: PCT/JP2015/054677
(87) International publication number: WO 2016/132518

(57) **Abstract**

The purpose of the present invention is to provide a signal processing device that performs processing suitable for a signal processing device that transmits and receives signals without contact. A signal processing device is provided with a plurality of signal transmission/reception units (13A-13C), a plurality of signal processing units (11A-11C), and a signal distribution unit (12). The signal transmission/reception units (13A-13C) can transmit and receive signals, without contact, between signal processing device-side signal transmission/reception units (41A-43A). Reception signals (Sin1-Sin3) received by the signal transmission/reception units (13A-13C) are inputted to the signal distribution unit (12). Output signals (Sout1-Sout3) outputted by the signal processing units (11A-11C) are inputted to the signal distribution unit (12). The signal distribution unit (12) can output the reception signals (Sin1-Sin3) to the signal processing units (11A-11C), and can output the output signals (Sout1-Sout3) to the signal transmission/reception units (13A-13C) .

## Description

### TECHNICAL FIELD

The present invention relates to a signal processing device that can transmit and receive signals to and from an external signal transmission/reception unit without contact.

### BACKGROUND ART

Conventionally, there has been known a signal processing device that transmits and receives signals to and from an external signal transmission/reception unit without contact. The signal processing device has a signal transmission/reception coil instead of a signal terminal in a general signal processing device. Signals are transmitted and received by inductive coupling between the signal transmission/reception coil in the signal processing device and the signal transmission/reception coil in the external signal transmission/reception unit without contact. The signal transmission/reception device is described in Patent Document 1 or Patent Document 2.
Patent Document 1: Japanese Unexamined Patent Application, Publication No. 2010-103611
Patent Document 2: Japanese Unexamined Patent Application, Publication No. 2011-66515

### DISCLOSURE OF THE INVENTION

### Problems to be Solved by the Invention

However, Patent Document 1 and Patent Document 2 describe the coil layout and circuit configuration for transmitting and receiving signals to and from another signal transmission/reception unit (signal transmission/reception coil) without contact, but do not describe the processing of signals transmitted and received without contact in the signal processing device. Therefore, there is a demand for a signal processing device that performs signal processing suitable for signals transmitted and received without contact.

An object of the present invention is to provide a signal processing device that performs processing suited for a signal processing device transmitting and receiving signals without contact.

### Means for Solving the Problems

The present invention relates to a signal processing device including: a plurality of signal transmission/reception units; a plurality of signal processing units; and a signal distribution unit that is electrically connected to the plurality of signal transmission/reception units and is electrically connected to the plurality of signal processing units, wherein each of the plurality of signal transmission/reception units can transmit and receive signals to and from a signal processing device-side signal transmission/reception unit outside of the signal processing device without contact, a reception signal received by each of the plurality of signal transmission/reception units is inputted to the signal distribution unit, an output signal outputted by each of the plurality of signal processing units is inputted to the signal distribution unit, the signal distribution unit can output the reception signal to each of the plurality of signal processing units and can output the output signal to each of the plurality of signal transmission/reception units.

The reception signal includes a first reception signal, the plurality of signal processing units includes a first signal processing unit, and the signal distribution unit can output the first reception signal to the first signal processing unit such that the first signal processing unit can process the first reception signal.

The first signal processing unit can process a signal including first identification data, and the signal distribution unit can output the first reception signal to the first signal processing unit such that the first signal processing unit can process the first reception signal by outputting the first reception signal to the first signal processing unit when the first reception signal includes the first identification data.

The signal processing device further includes a signal distribution instruction unit, the signal distribution unit has a plurality of switches, the distribution instruction unit outputs a switch open/close instruction signal for instructing the open/close state of each of the plurality of switches, and the signal distribution unit can output the first reception signal to the first signal processing unit such that the first signal processing unit can process the first reception signal by opening and closing the plurality of switches based on the switch open/close instruction signal.

The output signal includes a second output signal, the plurality of signal processing units includes a second signal processing unit that outputs the second output signal, and the signal distribution unit can output the second output signal to, out of the plurality of signal transmission/reception units, at least one signal transmission/reception unit that can transmit and receive signals to and from an external signal processing unit that can process the second output signal.

The external signal processing unit can process a signal including second identification data, and the signal distribution unit can output the second output signal to the at least one signal transmission/reception unit by outputting the second output signal to the at least one signal transmission/reception unit when the second output signal includes the second identification data.

The signal processing device further includes a signal distribution instruction unit, the signal distribution unit has a plurality of switches, the distribution instruction unit outputs a switch open/close instruction signal for instructing the open/close state of each of the plurality of switches, and the signal distribution unit can output the second output signal to the at least one signal transmission/reception unit by opening and closing the plurality of switches based on the switch open/close instruction signal.

The plurality of signal transmission/reception units is signal transmission/reception coils formed by wires, and the signal transmission/reception coils can transmit and receive signals to and from an external signal transmission/reception unit by inductive coupling.

The present invention also relates to a signal processing system including: the signal processing device; an interposer unit that has a plurality of signal processing device-side signal transmission/reception units as the plurality of external signal transmission/reception units and a plurality of signal processing unit-side signal transmission/reception units that is electrically connected to the plurality of signal processing device-side signal transmission/reception units; and an external signal processing unit that can transmit and receive signals to and from the plurality of signal processing unit-side signal transmission/reception units without contact, wherein the signal processing device and the external signal processing unit can transmit and receive signals to and from each other via the interposer unit.

The present invention also relates to a signal processing system including: the signal processing device; and an external signal processing unit that has a plurality of external signal processing unit signal transmission/reception units as the plurality of external signal transmission/reception units and transmits and receives signals to and from the signal processing device without contact.

### Effects of the Invention

According to the present invention, it is possible to provide a signal processing device that performs processing suitable for a signal processing device to transmit and receive signals without contact.

### BRIEF DESCRIPTION OF THE DRAWINGS

FIG. 1 is a block diagram of a signal processing system 1 in an embodiment of the present invention.
FIGS. 2A to 2C are diagrams for describing transmission/reception coils in the embodiment of the present invention. FIG. 2A illustrates a first signal transmission/reception coil 13A, FIG. 2B illustrates a first signal processing device-side coil 41A and a first external signal processing unit-side coil 41B in an interposer unit 40, and FIG. 2C illustrates a first external signal processing unit transmission/reception coil 23A.
FIGS. 3A and 3B are diagrams of the signal processing system 1 in the embodiment of the present invention. FIG. 3A is a plan view and FIG. 3B is a cross-sectional view taken along line A-A.

### PREFERRED MODE FOR CARRYING OUT THE INVENTION

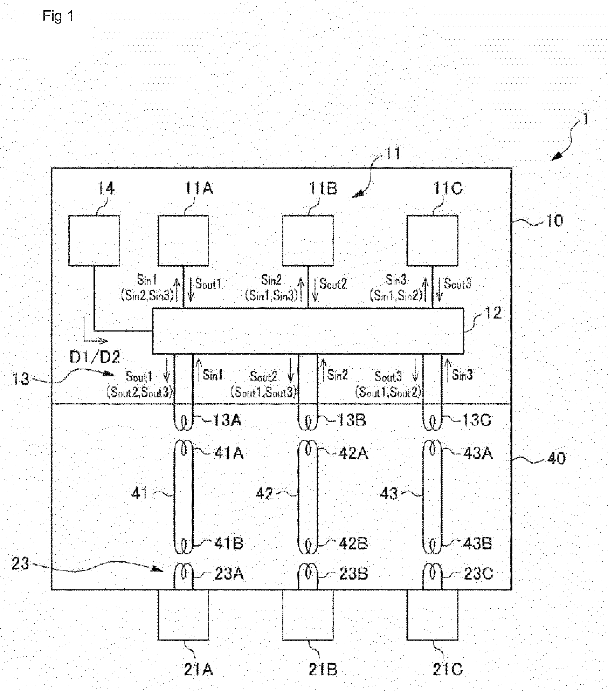

An embodiment of the present invention will be described below with reference to FIG. 1. FIG. 1 is a block diagram of a signal processing system 1 in the embodiment of the present invention.

In the following description, "transmitting and receiving signals without contact" means that one transmission/reception unit transmitting and receiving signals and the other transmission/reception unit transmitting and receiving signals transmit and receive signals to and from each other without contact and without intervention of a conductive member (one or more of solder, a conductive adhesive, and a wire). In addition, "transmitting and receiving signals with contact" means that one transmission/reception unit transmitting and receiving signals and the other transmission/reception units transmitting and receiving signals transmit and receive signals to and from each other in contact with each other or with intervention of a conductive member (solder, a conductive adhesive, or a wire).

As illustrated in FIG. 1, the signal processing system 1 includes a signal processing device 10, external signal processing units 21, and an interposer unit 40.

The signal processing device 10 includes a signal processing unit 11, a signal distribution unit 12, a signal transmission/reception coil 13 as a signal transmission/reception unit, and a signal distribution instruction unit 14.

The signal processing unit 11 includes three (a plurality of) signal processing units, that is, a first signal processing unit 11A, a second signal processing unit 11B, and a third signal processing unit 11C.

The signal transmission/reception coil 13 as the signal transmission/reception unit includes three (a plurality of) signal transmission/reception coils, that is, a first signal transmission/reception coil 13A (a first signal transmission/reception unit), a second signal transmission/reception coil 13B (a second signal transmission/reception unit), and a third signal transmission/reception coil 13C (a third signal transmission/reception unit).

The first signal processing unit 11A, the second signal processing unit 11B, and the third signal processing unit 11C are electrically connected to the signal distribution unit 12. The first signal transmission/reception coil 13A, the second signal transmission/reception coil 13B, and the third signal transmission/reception coil 13C are electrically connected to the signal distribution unit 12. The signal distribution instruction unit 14 is electrically connected to the signal distribution unit 12.

The external signal processing units 21 include three (a plurality of) external signal processing units, that is, a first external signal processing unit 21A, a second external signal processing unit 21B, and a third external signal processing unit 21C. The first external signal processing unit 21A is electrically connected to a first external signal processing unit transmission/reception coil 23A, the second external signal processing unit 21B is electrically connected to a second external signal processing unit transmission/reception coil 23B, and the third external signal processing unit 21C is electrically connected to a third external signal processing unit transmission/reception coil 23C.

The interposer unit 40 has three (a plurality of) signal paths (a first signal path 41, a second signal path 42, and a third signal path 43), three (a plurality of) signal processing device-side coils as signal processing device-side transmission/reception units (a first signal processing device-side coil 41A, a second signal processing device-side coil 42A, and a third signal processing device-side coil 43A), and three (a plurality of) external signal processing unit-side coils (a first external signal processing unit-side coil 41B, a second external signal processing unit-side coil 42B, and a third external signal processing unit-side coil 43B).

One end of the first signal path 41 is electrically connected to the first signal processing device-side coil 41A (the first signal processing device-side transmission/reception unit), and the other end of the first signal path 41 is electrically connected to the first external signal processing unit-side coil 41B (the first external signal processing device-side transmission/reception unit). One end of the second signal path 42 is electrically connected to the second signal processing device-side coil 42A (the second signal processing device-side transmission/reception unit), and the other end of the second signal path 42 is electrically connected to the second external signal processing unit-side coil 42B (the second external signal processing device-side transmission/reception unit). One end of the third signal path 43 is electrically connected to the third signal processing device-side coil 43A (the third signal processing device-side transmission/reception unit), and the other end of the third signal path 43 is electrically connected to the third external signal processing unit-side coil 43B (the third external signal processing device-side transmission/reception unit).

The first signal processing unit 11A, the second signal processing unit 11B, and the third signal processing unit 11C are signal processing units that perform respective predetermined signal processing. More specifically, the signal processing units perform predetermined processing on inputted signals and perform predetermined processing based on inputted signals. The signals processed by the signal processing units are outputted as output signals as necessary. Referring to FIG. 1, the first signal processing unit 11A, the second signal processing unit 11B, and the third signal processing unit 11C are signal processing units that are built in one package (for example, in the embodiment, a semiconductor chip acting as the signal processing device 10).

The first signal transmission/reception coil 13A can transmit and receive signals to and from the first signal processing device-side coil 41A without contact. More specifically, the first signal transmission/reception coil 13A can transmit and receive signals to and from the first signal processing device-side coil 41A by inductive coupling between the first signal transmission/reception coil 13A and the first signal processing device-side coil 41A. The foregoing matter also applies to the relationship between the second signal transmission/reception coil 13B and the second signal processing device-side coil 42A and the relationship between the third signal transmission/reception coil 13C and the third signal processing device-side coil 43A.

A plurality of reception signals is inputted to the signal distribution unit 12, that is, a first reception signal Sin1 received by the first signal transmission/reception coil 13A, a second reception signal Sin2 received by the second signal transmission/reception coil 13B, and a third reception signal Sin3 received by the third signal transmission/reception coil 13C. A plurality of output signals is inputted to the signal distribution unit 12, that is, a first output signal Sout1 outputted by the first signal processing unit 11A, a second output signal Sout2 outputted by the second signal processing unit 11B, and a third output signal Sout3 outputted by the third signal processing unit 11C.

The signal distribution instruction unit 14 provides instructions to the signal distribution unit 12. The signal distribution unit 12 can operate under instructions from the signal distribution instruction unit 14. The signal distribution unit 12 can also operate autonomously without instructions from the signal distribution instruction unit 14.

The signal distribution unit 12 can output the first reception signal Sin1, the second reception signal Sin2, and the third reception signal Sin3 to the first signal processing unit 11A, the second signal processing unit 11B, and the third signal processing unit 11C. The signal distribution unit 12 can output the first output signal Sout1, the second output signal Sout2, and the third output signal Sout3 to the first signal transmission/reception coil 13A, the second signal transmission/reception coil 13B, and the third signal transmission/reception coil 13C.

The first external signal processing unit 21A, the second external signal processing unit 21B, and the third external signal processing unit 21C are signal processing units that perform respective predetermined signal processing. More specifically, the external signal processing units perform predetermined processing on inputted signals and perform predetermined processing based on inputted signals. The signals processed by the external signal processing units are outputted as output signals as necessary. Referring to FIG. 1, the first external signal processing unit 21A, the second external signal processing unit 21B, and the third external signal processing unit 21C are signal processing units that are built in respective independent packages (for example, semiconductor chips).

The first external signal processing unit transmission/reception coil 23A can transmit and receive signals to and from the first external signal processing unit-side coil 41B without contact. More specifically, the first external signal processing unit transmission/reception coil 23A can transmit and receive signals to and from the first external signal processing unit-side coil 41B without contact by inductive coupling between the first external signal processing unit transmission/reception coil 23A and the first external signal processing unit-side coil 41B. The foregoing matter also applies to the relationship between the second external signal processing unit transmission/reception coil 23B and the second external signal processing unit-side coil 42B and the relationship between the third external signal processing unit transmission/reception coil 23C and a third external signal processing unit-side coil 42C.

One example of operations of the signal processing system 1 in the embodiment will be described with reference to FIG. 1. First, the flows of reception signals received by the signal transmission/reception coils 13 will be described.

As illustrated in FIG. 1, the first signal transmission/reception coil 13A receives the first reception signal Sin1. The first reception signal Sin1 is a signal outputted from the first external signal processing unit 21A. The second signal transmission/reception coil 13B receives the second reception signal Sin2. The second reception signal Sin2 is a signal outputted from the second external signal processing unit 21B. The third signal transmission/reception coil 13C receives the third reception signal Sin3. The third reception signal Sin3 is a signal outputted from the third external signal processing unit 21C.

The first reception signal Sin1 received by the first signal transmission/reception coil 13A is inputted to the signal distribution unit 12. As described above, the first reception signal Sin1 is a signal outputted from the first external signal processing unit 21A and received by the first signal transmission/reception coil 13A via the first external signal processing unit transmission/reception coil 23A, the first external signal processing unit-side coil 41B, the first signal path 41, and the first signal processing device-side coil 41A.

As described above, the signal distribution unit 12 can output the first reception signal Sin1 to each of the first signal processing unit 11A, the second signal processing unit 11B, and the third signal processing unit 11C. In the embodiment, the signal distribution unit 12 outputs the first reception signal Sin1 to each of the first signal processing unit 11A, the second signal processing unit 11B, and the third signal processing unit 11C.

The first signal processing unit 11A, the second signal processing unit 11B, and the third signal processing unit 11C are signal processing units in conformity with specific standards. When inputted signals are standardized signals, the first signal processing unit 11A, the second signal processing unit 11B, and the third signal processing unit 11C perform predetermined processing on the inputted signal or perform predetermined processing based on the inputted signals. The first external signal processing unit 21A, the second external signal processing unit 21B, and the third external signal processing unit 21C are signal processing units in conformity with the specific standards and output standardized signals.

For example, when the inputted signal includes first identification data Rid1, the first signal processing unit 11A processes the inputted signal, and when the inputted signal does not include the first identification data Rid1, the first signal processing unit 11A does not process the inputted signal. Similarly, when the inputted signal includes second identification data Rid2 as predetermined identification data, the second signal processing unit 11B processes the inputted signal, and when the inputted signal does not include the second identification data Rid2, the second signal processing unit 11B does not process the inputted signal. Similarly, when the inputted signal includes third identification data Rid3 as predetermined identification data, the third signal processing unit 11C processes the inputted signal, and when the inputted signal does not include the third identification data Rid3, the third signal processing unit 11C does not process the inputted signal.

The first reception signal Sin1 includes the first identification data Rid1. The first reception signal Sin1 does not include the second identification data Rid2 and the third identification data Rid3. Accordingly, the first signal processing unit 11A processes the inputted first reception signal Sin1. The second signal processing unit 11B and the third signal processing unit 11C do not process the inputted first reception signal Sin1. The first reception signal Sin1 may include the second identification data Rid2 and/or the third identification data Rid3 as well. In this case, the second signal processing unit 11B and/or the third signal processing unit 11C process the first reception signal Sin1.

In this manner, the signal distribution unit 12 outputs the first reception signal Sin to the first signal processing unit 11A such that the first signal processing unit 11A can process the first reception signal Sin1.

The case in which the first reception signal Sin1 is received by the first signal transmission/reception coil 13A has been described so far. However, it is to be noted that the first reception signal Sin1 may be received by the second signal transmission/reception coil 13B and the third signal transmission/reception coil 13C. Specifically, the signal distribution unit 12 can output the first reception signal Sin to the first signal processing unit 11A such that the first signal processing unit 11A can process the first reception signal Sin1 even though the position of the first external signal processing unit 21A outputting the first reception signal Sin1 is exchanged with the position of the second external signal processing unit 21B or the third external signal processing unit 21C and the first reception signal Sin1 is outputted via the second external signal processing unit-side coil 42B or the third external signal processing unit-side coil 43B and received by the second signal transmission/reception coil 13B or the third signal transmission/reception coil 13C.

Accordingly, the external signal processing unit (the first external signal processing unit 21A) outputting the specific standardized signal (the first reception signal Sin1) does not need to transmit and receive signals to and from the specific signal transmission/reception unit (the first external signal processing unit-side coil 41B) but may transmit and receive signals to and from any one of the signal transmission/reception units (the first external signal processing unit-side coil 41B, the second external signal processing unit-side coil 42B, and the third external signal processing unit-side coil 43B). Accordingly, the signal processing device 10 of the embodiment provides the advantage of improving the degree of freedom to arrange the external signal processing units. As described above, the signal processing device 10 is a device that performs processing suitable for transmitting and receiving signals without contact. This advantage results from the signal processing device 10 of this embodiment that transmits and receives signals without contact.

In the case of a normal signal processing device (a signal processing device that transmits and receives signals with contact between a signal terminal and an external terminal), the wiring in the signal processing device connected to the signal terminal needs impedance matching according to the frequency of the signal and the like. Accordingly, it is impossible to connect an arbitrary external processing device to an arbitrary signal terminal. When an external signal processing device outputting a signal not in conformity with impedance matching is connected, signal reflection or the like occurs to disable transmission and reception of signals between the signal processing device and the external signal processing device. In contrast to this, the signal processing device 10 of the embodiment transmits and receives signals without contact, which eliminates the need for the impedance matching described above (or which lessens the required accuracy of the impedance matching as compared to the general signal processing device). Accordingly, the signal processing device 10 of the embodiment provides the advantage of improving the degree of freedom to arrange the external signal processing units.

The foregoing description of the first reception signal Sin1 also applies to the second reception signal Sin2 and the third reception signal Sin3. That is, the positions of the first external signal processing unit 21A, the second external signal processing unit 21B, and the third external signal processing unit 21C can be exchanged with one another.

Next, the flow of output signals outputted from the signal processing unit 11 will be described. As illustrated in FIG. 1, the first signal processing unit 11A outputs the first output signal Sout1. The second signal processing unit 11B outputs the second output signal Sout2. The third signal processing unit 11C outputs the third output signal Sout3. The second output signal Sout2 outputted from the second signal processing unit 11B is inputted to the signal distribution unit 12.

As described above, the signal distribution unit 12 can output the second output signal Sout2 to each of the first signal transmission/reception coil 13A, the second signal transmission/reception coil 13B, and the third signal transmission/reception coil 13C. In the embodiment, the second output signal Sout2 is outputted to each of the first signal transmission/reception coil 13A, the second signal transmission/reception coil 13B, and the third signal transmission/reception coil 13C.

Accordingly, the second output signal Sout2 is outputted from the first signal transmission/reception coil 13A, the second signal transmission/reception coil 13B, and the third signal transmission/reception coil 13C. The second output signal Sout2 outputted from the second signal transmission/reception coil 13B is received by the second external signal processing unit 21B via the second signal processing device-side coil 42A, the second signal path 42, the second external signal processing unit-side coil 42B, and the second external signal processing unit transmission/reception coil 23B. The second output signal Sout2 is outputted from the first signal transmission/reception coil 13A and the third signal transmission/reception coil 13C as well and is received by the first external signal processing unit 21A and the third external signal processing unit 21C as well.

As described above, the first signal processing unit 11A, the second signal processing unit 11B, and the third signal processing unit 11C are signal processing units in conformity with specific standards and output standardized signals. In addition, the first external signal processing unit 21A, the second external signal processing unit 21B, and the third external signal processing unit 21C are signal processing units in conformity with the specific standards. When the inputted signals are standardized signals, the first external signal processing unit 21A, the second external signal processing unit 21B, and the third external signal processing unit 21C perform predetermined processing on the inputted signals or perform predetermined processing based on the inputted signals.

For example, when the inputted signal includes the first identification data Rid1, the first external signal processing unit 21A processes the inputted signal, and when the inputted signal does not include the first identification data Rid1, the first external signal processing unit 21A does not process the inputted signal. Similarly, when the inputted signal includes the second identification data Rid2 as predetermined identification data, the second external signal processing unit 21B processes the inputted signal, and when the inputted signal does not include the second identification data Rid2, the second external signal processing unit 21B does not process the inputted signal. Similarly, when the inputted signal includes the third identification data Rid3 as predetermined identification data, the third external signal processing unit 21C processes the inputted signal, and when the inputted signal does not include the third identification data Rid3, the third external signal processing unit 21C does not process the inputted signal.

The second output signal Sout2 includes the second identification data Rid2. The second output signal Sout2 does not include the first identification data Rid1 and the third identification data Rid3. Therefore, the second external signal processing unit 21B processes the inputted second output signal Sout2. The first external signal processing unit 21A and the third external signal processing unit 21C do not process the inputted second output signal Sout2. The second output signal Sout2 may include the first identification data Rid1 and/or the third identification data Rid3. In this case, the first external signal processing unit 21A and/or the third external signal processing unit 21C process the second output signal Sout2.

In this manner, the signal distribution unit 12 outputs the second output signal Sout2 to, out of the plurality of signal transmission/reception units, at least the second signal transmission/reception coil 13B as one of the signal transmission/reception units that can transmit and receive signals to and from the second external signal processing unit 21B that can process the second output signal Sout2.

The case in which the second output signal Sout2 is outputted to the second signal transmission/reception coil 13B has been described so far. However, it is to be noted that the second output signal Sout2 may be outputted to the first signal transmission/reception coil 13A and the third signal transmission/reception coil 13C. Specifically, the signal distribution unit 12 can output the second output signal Sout2 to, out of the plurality of signal transmission/reception units, at least one signal transmission/reception unit (the first signal transmission/reception coil 13A or the third signal transmission/reception coil 13C) that can transmit and receive signals to and from the second external signal processing unit 21B that can process the second output signal Sout2 even though the position of the second external signal processing unit 21B capable of processing the second output signal Sout2 is exchanged with the first external signal processing unit 21A or the third external signal processing unit 21C and the second output signal Sout2 is outputted via the first signal transmission/reception coil 13A or the third signal transmission/reception coil 13C and is received by the first signal processing device-side coil 41A or the third signal processing device-side coil 43A.

This eliminates the need for the external signal processing unit (the second external signal processing unit 21B) receiving the specific standardized signal (the second output signal Sout2) to transmit and receive signals to and from the specific signal transmission/reception unit (the second external signal processing unit-side coil 42B). Accordingly, the signal processing device 10 of the embodiment provides the advantage of improving the degree of freedom to arrange the external signal processing units. In this manner, the signal processing device 10 performs processing suitable for transmitting and receiving signals without contact. This advantage results from the signal processing device 10 of the embodiment transmitting and receiving signals without contact. The reason for this is the same as that described above about the first reception signal Sin1.

As described above, in the signal processing system 1 of the embodiment, the signal processing device 10 and the external signal processing units 21 (the first external signal processing unit 21A, the second external signal processing unit 21B, and the third external signal processing unit 21C) transmit and receive signals to and from each other via the interposer unit 40.

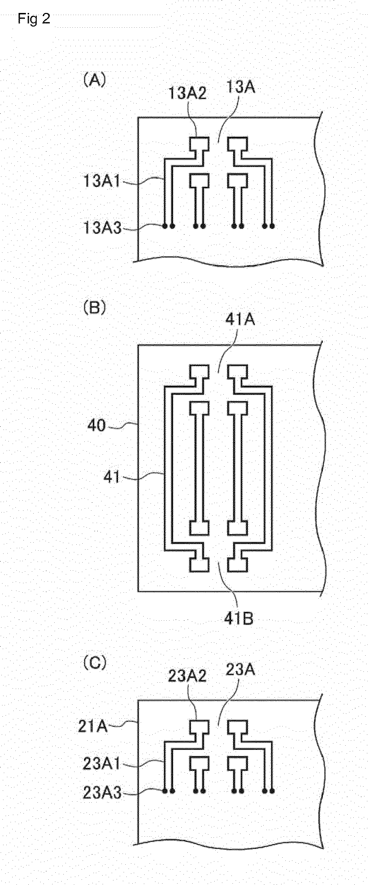

Next, configurations of the signal transmission/reception coils in the signal processing device 10, the external signal processing units 21, and the interposer unit 40 will be described with reference to FIGS. 2A to 2C. FIGS. 2A to 2C are diagrams for describing the transmission/reception coils in the embodiment of the present invention. FIG. 2A illustrates the first signal transmission/reception coil 13A, FIG. 2B illustrates the first signal processing device-side coil 41A and the first external signal processing unit-side coil 41B in the interposer unit 40, and FIG. 2C illustrates the first external signal processing unit transmission/reception coil 23A.

As illustrated in FIG. 2A, the first signal transmission/reception coil 13A includes a wire 13A1 and a single winding of coil 13A2 formed by the wire 13A1 at one end of the wire 13A1. The other end of the wire 13A1 is connected to a via hole 13A3. As illustrated in FIG. 2A, three (a plurality of) signal transmission/reception coils configured in the same manner as described above are arranged in the vicinity of the first signal transmission/reception coil 13A. The second signal transmission/reception coil 13B and the third signal transmission/reception coil 13C are configured in the same manner as described above.

As illustrated in FIG. 2B, the first signal processing device-side coil 41A and the first external signal processing unit-side coil 41B include a first signal path 41 formed by the wire and single-winding coils 41A1 and 41B1 formed by the wire. As illustrated in FIG. 2B, three (a plurality of) signal reception coils configured in the same manner as described are arranged in the vicinity of the first signal processing device-side coil 41A and the first external signal processing unit-side coil 41B. The second signal processing device-side coil 42A and the second external signal processing unit-side coil 42B, and the third signal processing device-side coil 43A and the third external signal processing unit-side coil 43B are configured in the same manner as described above.

As illustrated in FIG. 2C, the first external signal processing unit transmission/reception coil 23A includes a wire 23A1 and a single winding of coil 23A2 formed by the wire 23A1 at one end of the wire 23A1. The other end of the wire 23A1 is connected to a via hole 23A3. As illustrated in FIG. 2C, three (a plurality of) signal transmission/reception coils configured in the same manner as described above are arranged in the vicinity of the first external signal processing unit transmission/reception coil 23A. The second external signal processing unit transmission/reception coil 23B and the third external signal processing unit transmission/reception coil 23C are configured in the same manner as described above.

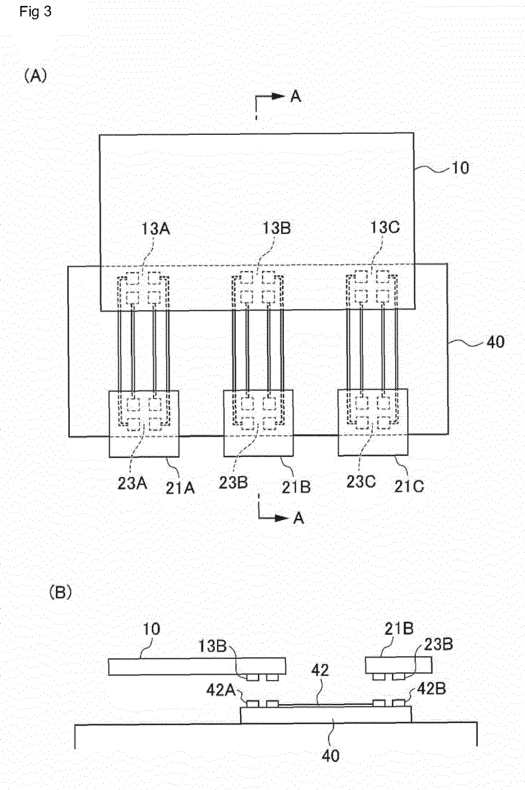

Next, the layout of the signal processing device 10, the external signal processing units 21, and the interposer unit 40 will be described with reference to FIGS. 3A and 3B. FIGS. 3A and 3B are diagrams of the signal processing system 1 in the embodiment of the present invention. FIG. 3A is a plan view and FIG. 3B is a cross-sectional view taken along line A-A.

As illustrated in FIGS. 3A and 3B, the signal processing device 10 and the interposer unit 40 are arranged such that the signal transmission/reception coils 13 (the first signal transmission/reception coil 13A to the third signal transmission/reception coil 13C) in the signal processing device 10 and the signal processing device-side coils (the first signal processing device-side coil 41A to the third signal processing device-side coil 43A) in the interposer unit 40 are opposed to each other. As illustrated in FIG. 3B, the signal transmission/reception coils 13 (the first signal transmission/reception coil 13A to the third signal transmission/reception coil 13C) and the signal processing device-side coils (the first signal processing device-side coil 41A to the third signal processing device-side coil 43A) are separated from each other without contact. The signal transmission/reception coils 13 (the first signal transmission/reception coil 13A to the third signal transmission/reception coil 13C) and the signal processing device-side coils (the first signal processing device-side coil 41A to the third signal processing device-side coil 43A) can transmit and receive signals to and from each other by inductive coupling.

The external signal processing units 21 and the interposer unit 40 are arranged such that the external signal processing units 23 (the first external signal processing unit transmission/reception coil 23A to the third external signal processing unit transmission/reception coil 23C) and the external signal processing unit-side coils 41B to 43B are opposed to each other. As illustrated in FIG. 3B, the external signal processing units 23 (the first external signal processing unit transmission/reception coil 23A to the third external signal processing unit transmission/reception coil 23C) and the external signal processing unit-side coils (the first external signal processing unit-side coil 41B to the third external signal processing unit-side coil 43B) are separated from each other without contact. The external signal processing units 23 (the first external signal processing unit transmission/reception coil 23A to the third external signal processing unit transmission/reception coil 23C) and the external signal processing unit-side coils (the first external signal processing unit-side coil 41B to the third external signal processing unit-side coil 43B) can transmit and receive signals to and from each other by inductive coupling.

In the embodiment, the signal distribution unit 12 outputs the first reception signal Sin1 to each of the first signal processing unit 11A, the second signal processing unit 11B, and the third signal processing unit 11C. However, the present invention is not limited to this. When the first reception signal Sin1 includes the first identification data Rid1, the signal distribution unit 12 may output the first reception signal Sin1 to the first signal processing unit 11A, and when the first reception signal Sin1 does not include the first identification data Rid1, the signal distribution unit 12 may not output the first reception signal Sin1 to the first signal processing unit 11A. In this case, the signal distribution unit 12 outputs the first reception signal Sin1 to the first signal processing unit 11A such that the first signal processing unit 11A can process the first reception signal Sin1 by outputting the first reception signal Sin1 to the first signal processing unit 11A when the first reception signal Sin1 includes the first identification data Rid1.

The signal distribution unit 12 outputs the second output signal Sout2 to each of the first signal transmission/reception coil 13A, the second signal transmission/reception coil 13B, and the third signal transmission/reception coil 13C. However, the present invention is not limited to this. When the second output signal Sout2 includes the second identification data Rid2, the signal distribution unit 12 may output the second output signal Sout2 to the second signal transmission/reception coil 13B, and when the second output signal Sout2 does not include the second identification data Rid2, the signal distribution unit 12 may not output the second output signal Sout2 to the second signal transmission/reception coil 13B. In this case, the signal distribution unit 12 outputs the second output signal Sout2 to the second signal transmission/reception coil 13B such that the second external signal processing unit 21B can process the second output signal Sout2 by outputting the second output signal Sout2 to the second signal transmission/reception coil 13B when the second output signal Sout2 includes the second identification data Rid2.

The signal distribution unit 12 may include a plurality of switches. The signal distribution instruction unit 14 may output a switch open/close signal for instructing the open/close state of each of the plurality of switches.

In this case, the signal distribution unit 12 outputs the first reception signal Sin1 to the first signal processing unit 11A such that the first signal processing unit 11A can process the first reception signal Sin1 by opening and closing the plurality of switches based on the switch open/close instruction signal outputted from the signal distribution instruction unit 14.

Further, the signal distribution unit 12 outputs the second output signal Sout2 to the second signal transmission/reception coil 13B such that the second external signal processing unit 21B can process the second output signal Sout2 by opening and closing the plurality of switches based on the switch open/close instruction signal outputted from the signal distribution instruction unit 14.

In the signal processing system 1 of the embodiment, the signal processing device 10 and the external signal processing units 21 (the first external signal processing unit 21A, the second external signal processing unit 21B, and the third external signal processing unit 21C) transmit and receive signals to and from each other via the interposer unit 40. However, the present invention is not limited to this. The signal processing device 10 and the external signal processing units 21 (the first external signal processing unit 21A, the second external signal processing unit 21B, and the third external signal processing unit 21C) may transmit and receive signals to and from each other without contact and without intervention of the interposer unit 40. Specifically, the signal transmission/reception coils 13 (the first signal transmission/reception coil 13A, the second signal transmission/reception coil 13B, and the third signal transmission/reception coil 13C) in the signal processing device 10 and the external signal processing unit transmission/reception units (the first external signal processing unit transmission/reception coil 23A, the second external signal processing unit transmission/reception coil 23B, and the third external signal processing unit transmission/reception coil 23C) may transmit and receive signals to and from each other without contact.

The coils in the embodiment are single windings of coils as illustrated in FIGS. 2A to 2C but may be plural windings of coils instead.

In the embodiment, the transmission and reception of signals without contact are carried out by inductive coupling between coils. However, the present invention is not limited to this. The transmission and reception of signals without contact may be transmission and reception of signals without contact by the use of magnetic resonance between coils or transmission and reception of signals without contact by the use of optical signals or sound wave signals.

In the embodiment, the three signal processing units 11 and the three external signal processing units 21 are provided. However, the present invention is not limited to this. There may be one signal processing unit 11 or more and one external signal processing unit 21 or more. In the embodiment, the first external signal processing unit 21A, the second external signal processing unit 21B, and the third external signal processing unit 21C are built in respective independent packages. However, the present invention is not limited to this. Some or all of the first external signal processing unit 21A, the second external signal processing unit 21B, and the third external signal processing unit 21C may be built in one package. The first signal processing unit 11A, the second signal processing unit 11B, and the third signal processing unit 11C may be signal processing units having different functions, or some or all of the first signal processing unit 11A, the second signal processing unit 11B, and the third signal processing unit 11C may be signal processing units having the same function. The first external signal processing unit 21A, the second external signal processing unit 21B, and the third external signal processing unit 21C may be signal processing units having different functions, or some or all of the first external signal processing unit 21A, the second external signal processing unit 21B, and the third external signal processing unit 21C may be signal processing units having the same function.

In this embodiment, three of each of (three sets of) signal transmission/reception coils, signal paths, and external signal transmission/reception coils are provided. However, the present invention is not limited to this. An arbitrary number or arbitrary sets of the signal transmission/reception coils, signal paths, and external signal transmission/reception coils may be provided.

### EXPLANATION OF REFERENCE NUMERALS

1 Signal processing system
10 Signal processing device
11 Signal processing unit
11A First signal processing unit
11B Second signal processing unit
11C Third signal processing unit
12 Signal distribution unit
13 Signal transmission/reception coil (signal transmission/reception unit)
13A First signal transmission/reception coil (first signal transmission/reception unit)
13B Second signal transmission/reception coil (second signal transmission/reception unit)
13C Third signal transmission/reception coil (third signal transmission/reception unit)
14 Signal distribution instruction unit
21 External signal processing unit
21A First external signal processing unit
21B Second external signal processing unit
21C Third external signal processing unit
23 External signal processing unit transmission/reception unit
23A First external signal processing unit transmission/reception coil (first external signal processing unit transmission/reception unit)
23B Second external signal processing unit transmission/reception coil (second external signal processing unit transmission/reception unit)
23C Third external signal processing unit transmission/reception coil (third external signal processing unit transmission/reception unit)
40 Interposer unit
41 First signal path
41A First signal processing device-side coil (signal processing device-side transmission/reception unit)
41B First external signal processing unit-side coil 42 Second signal path
42A Second signal processing device-side coil (signal processing device-side transmission/reception unit)
42B Second external signal processing unit-side coil
43 Third signal path
43A Third signal processing device-side coil (signal processing device-side transmission/reception unit)
43B Third external signal processing unit-side coil
34 Bridge signal distribution instruction unit
Sin1 First reception signal
Sin2 Second reception signal
Sin3 Third reception signal
Sout1 First output signal
Sout2 Second output signal
Sout3 Third output signal

## Claims

1. A signal processing device comprising:
a plurality of signal transmission/reception units;
a plurality of signal processing units; and
a signal distribution unit that is electrically connected to the plurality of signal transmission/reception units and is electrically connected to the plurality of signal processing units, wherein
each of the plurality of signal transmission/reception units can transmit and receive signals to and from a signal processing device-side signal transmission/reception unit outside of the signal processing device without contact,
a reception signal received by each of the plurality of signal transmission/reception units is inputted to the signal distribution unit,
an output signal outputted by each of the plurality of signal processing units is inputted to the signal distribution unit, and
the signal distribution unit can output the reception signal to each of the plurality of signal processing units and can output the output signal to each of the plurality of signal transmission/reception units.

2. The signal processing device according to claim 1, wherein
the reception signal includes a first reception signal,
the plurality of signal processing units includes a first signal processing unit, and
the signal distribution unit can output the first reception signal to the first signal processing unit such that the first signal processing unit can process the first reception signal.

3. The signal processing device according to claim 2, wherein
the first signal processing unit can process a signal including first identification data, and
the signal distribution unit can output the first reception signal to the first signal processing unit such that the first signal processing unit can process the first reception signal by outputting the first reception signal to the first signal processing unit when the first reception signal includes the first identification data.

4. The signal processing device according to claim 2,
further comprising a signal distribution instruction unit, wherein
the signal distribution unit has a plurality of switches, the signal distribution instruction unit outputs a switch open/close instruction signal for instructing open/close state of each of the plurality of switches, and
the signal distribution unit outputs the first reception signal to the first signal processing unit such that the first signal processing unit can process the first reception signal by opening and closing the plurality of switches based on the switch open/close instruction signal.

5. The signal processing device according to claim 1, wherein
the output signal includes a second output signal,
the plurality of signal processing units includes a second signal processing unit that outputs the second output signal, and
the signal distribution unit outputs the second output signal to, among the plurality of signal transmission/reception units, at least one signal transmission/reception unit that can transmit and receive signals to and from an external signal processing unit that can process the second output signal.

6. The signal processing device according to claim 5, wherein
the external signal processing unit can process a signal including second identification data, and
the signal distribution unit outputs the second output signal to the at least one signal transmission/reception unit by outputting the second output signal to the at least one signal transmission/reception unit when the second output signal includes the second identification data.

7. The signal processing device according to claim 5,
further comprising a signal distribution instruction unit, wherein
the signal distribution unit has a plurality of switches, the signal distribution instruction unit outputs a switch open/close instruction signal for instructing open/close state of each of the plurality of switches, and
the signal distribution unit outputs the second output signal to the at least one signal transmission/reception unit by opening and closing the plurality of switches based on the switch open/close instruction signal.

8. The signal processing device according to any one of claims 1 to 7, wherein
the plurality of signal transmission/reception units are signal transmission/reception coils formed by wires, and the signal transmission/reception coils can transmit and receive signals to and from an external signal transmission/reception unit by inductive coupling.

9. A signal processing system comprising:
the signal processing device according to any one of claims 1 to 8;
an interposer unit that has a plurality of signal processing device-side signal transmission/reception units as the plurality of external signal transmission/reception units and a plurality of signal processing unit-side signal transmission/reception units that are electrically connected to the plurality of signal processing device-side signal transmission/reception units; and
an external signal processing unit that can transmit and receive signals to and from the plurality of signal processing unit-side signal transmission/reception units without contact,
wherein
the signal processing device and the external signal processing unit transmit and receive signals to and from each other via the interposer unit.

10. A signal processing system comprising:
the signal processing device according to any one of claims 1 to 8; and
an external signal processing unit that has a plurality of external signal processing unit signal transmission/reception units as the plurality of external signal transmission/reception units, and transmits and receives signals to and from the signal processing device without contact.
